# EUROPEAN PATENT APPLICATION

(11) **EP 1 387 416 A2**
(43) Date of publication of application: **04.02.2004**
(21) Application number: 03254612.9
(22) Date of filing: 24.07.2003
(51) Int. Cl.: H01L 41/09

(54) **Piezoelectric/electrostrictive film type device**

(30) Priority: 26.07.2002 US 398917 P; 10.06.2003 JP 2003165334
(71) Applicant: NGK INSULATORS, LTD., Nagoya-City, Aichi Prefecture 467-8530 (JP)
(72) Inventor: Murasato, Masahiro, c/o I.P.D. NGK Insulators Ltd, Nagoya-city, Aichi-ken, 467-8530 (JP); Bessho, Yuki, c/o I.P.D. NGK Insulators Ltd, Nagoya-city, Aichi-ken, 467-8530 (JP)
(74) Representative: Paget, Hugh Charles Edward

(57) **Abstract**

A piezoelectric/electrostrictive film type device includes a substrate (44) formed of a ceramic and a piezoelectrlc/electrostrictive operation portion (78) in which at least one piezoelectric/electrostrictive layer (73) and at least one pair of electrodes (75,77) electrically connected to the piezoelectric/electrostrictive layer are stacked on the substrate. In the device, an outer surface of the piezoelectric/electrostrictive layer is subjected to surface modification to obtain a highly water repellent surface for inhibiting infiltration of moisture (91) into micro-pores (81) opened in the outer surface or into a gap between the substrate and the piezoelectric/electrostrictive layer. The piezoelectric/electrostrictive film type device has flexural displacement and durability equal to or more than those of a conventional piezoelectric/electrostrictive film type device and has a relatively high resonance frequency and is superior in high-speed response.

## Description

### BACKGROUND OF THE INVENTION

### Field of the Invention

The present invention relates to a piezoelectric/electrostrictive film type device. More particularly, the present invention relates to a piezoelectric/electrostrictive film type device which has, on a substrate made of a ceramic, at least one piezoelectric/electrostrictive layer made of a piezoelectric/electrostrictive ceramic composition and at least one pair of electrodes electrically connected to the piezoelectric/electrostrictive layer.

### Description of the Related Art

A piezoelectric/electrostrictive film type device can control a minute displacement and moreover has superior properties such as a high electromechanical transduction efficiency, high-speed response, high durability, and low power consumption. Therefore, the device has been used in various applications such as a displacement control device, solid device motor, ink jet head, relay, switch, shutter, pump, optical modulation device, and fin.

Moreover, as a conventional piezoelectric/electrostrictive film type device, a so-called sandwiched piezoelectric/electrostrictive film type device has been known including a piezoelectric/electrostrictive operation portion in which a lower electrode, piezoelectric/electrostrictive layer, and upper electrode are stacked in order on a substrate of a ceramic (See JP-A-6-260694). Moreover, a so-called multilayered piezoelectric/electrostrictive film type device has broadly been known including the piezoelectric/electrostrictive operation portion which includes a plurality of piezoelectric/electrostrictive layers and electrodes on the substrate of the ceramic and in which negative and positive electrodes are alternately held between the respective piezoelectric/electrostrictive layers (See JP-A-5-124188). For the former sandwiched piezoelectric/electrostrictive film type device, the piezoelectric/electrostrictive operation portion is very thin, and therefore the device has advantages that flexural displacement of the piezoelectric/electrostrictive operation portion is large with respect to strain of the piezoelectric /electrostrictive device at a voltage applying time. For the latter multilayered piezoelectric/electrostrictive film type device, a plurality of piezoelectric/electrostrictive layers are stacked, the strain of the piezoelectric/electrostrictive layers can therefore be integrated, and the device has advantages that displacement in the same direction as that of the strain can be enlarged.

Additionally, in these piezoelectric/electrostrictive film type devices, it is naturally required that insulation is secured between the respective electrodes and that dielectric breakdown of the piezoelectric/electrostrictive layer is avoided in order to secure basic properties of the device. Therefore, various attempts have been made to avoid the dielectric breakdown.

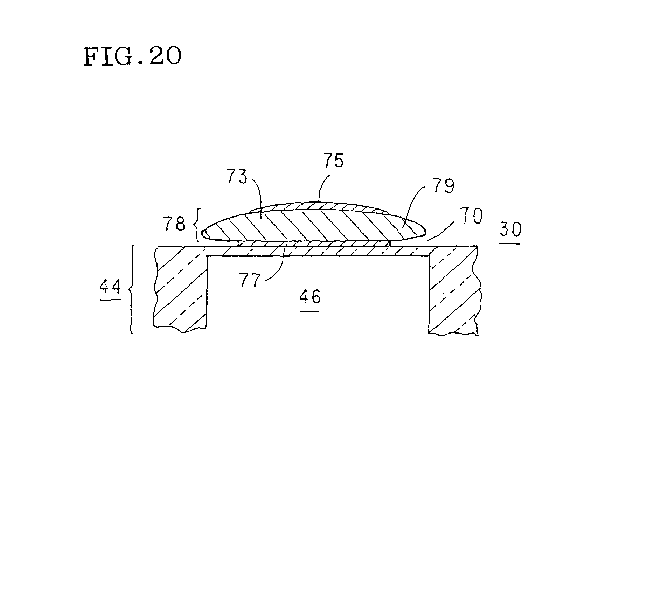

For example, as shown in FIG. 20, a piezoelectric/electrostrictive film type device 30 has been developed including a piezoelectric/electrostrictive layer 73 disposed in such a size that an upper surface of a lower electrode 77 is coated and an end of the layer projects onto a substrate 44 (See JP-A-6-260694).

In this piezoelectric/electrostrictive film type device 30, a projecting portion 79 of the piezoelectric/electrostrictive layer 73 is solidly attached directly to the substrate 44 of alumina, the opposite ends of the piezoelectric/electrostrictive layer 73 are accordingly fixed, and the layer is inhibited from contracting/expanding (the piezoelectric/electrostrictive layer contracts/expands in a direction vertical to a thickness direction by the application of the voltage). The flexural displacement is therefore reduced, and the projecting portion 79 is usually disposed in an incompletely bonded state with respect to the substrate 44 (See JP-A-6-260694).

On the other hand, in the piezoelectric/electrostrictive film type device, from demands for high integration and displacement, the thickness of one piezoelectric/electrostrictive layer has tended to be reduced to 20 µm or less. However, at a manufacturing time, organic compounds such as a binder are contained in a ceramic material. Therefore, micro-pores having a diameter of 0.5 to 5 µm are formed in the sintered piezoelectric/ electrostrictive layer, and some of the holes are opened in an outer surface of the piezoelectric/ electrostrictive layer (See JP-A-5-124188). The micro-pores opened in the outer surface are sometimes formed through the upper electrode formed in the piezoelectric/electrostrictive layer upper part.

Therefore, when these piezoelectric/electrostrictive film type devices are used in a high-humidity environment easily causing dew condensation, moisture enters the micro-pores opened in the outer surface of the piezoelectric/electrostrictive layer, and an insulation distance of the piezoelectric/electrostrictive layer is reduced. In the device in which a relatively thin piezoelectric/electrostrictive layer is disposed, there is a problem that the dielectric breakdown occurs between the upper electrode and intermediate electrode or between the intermediate electrode and lower electrode. Since moisture adsorption (adhesion) into the surface of the piezoelectric/electrostrictive device is promoted by the presence of the micro-pores, a surface leak current is generated and the dielectric breakdown sometimes occurs.

Furthermore, in the piezoelectric/electrostrictive film type device 30 in which the end of the piezoelectric/electrostrictive layer 73 projects onto the substrate 44 as shown in FIG. 20, the moisture infiltrates into a gap 70 (0.2 to 10 µm) between the projecting portion 79 of the piezoelectric/electrostrictive layer 73 and the substrate 44, and this causes peels of the piezoelectric/electrostrictive layer 73.

On the other hand, a so-called multilayered piezoelectric/electrostrictive film type device has been disclosed in which an oxide layer for coating the surface of the piezoelectric/electrostrictive layer and for filling the micro-pores opened in the surface is formed on the piezoelectric/electrostrictive layer (Japanese Patent Application Laid-Open No. 5-124188). According to the piezoelectric/electrostrictive film type device, the infiltration of the moisture into the micro-pores can completely be avoided.

However, in the piezoelectric/electrostrictive film type device, as a result of lamination of the oxide layer with which the micro-pores opened in the surface of the piezoelectric/electrostrictive layer are filled and with which the surface of the piezoelectric/electrostrictive layer is coated, the piezoelectric/electrostrictive layer is restricted by the oxide layer, and a rise of bend moment is caused. There is a problem that the flexural displacement of the piezoelectric/electrostrictive layer is reduced. When a material other than the piezoelectric/electrostrictive device material is inserted in an opened micro-pore portion, the displacement is sometimes inhibited. Especially, in the so-called multilayered piezoelectric/electrostrictive film type device, since only the piezoelectric/electrostrictive layer positioned mainly in an uppermost layer is influenced by the oxide layer, the influence is relatively small. However, in the device in which the number of stacked piezoelectric/electrostrictive layers is small, such as the sandwiched piezoelectric/electrostrictive film type device, the influence is very large. There has been a strong demand for means for preventing the dielectric breakdown by the infiltration of the moisture regardless of the coat or the filled opened micro-pores.

### SUMMARY OF THE INVENTION

The present invention has been developed in consideration of the above-described problem, and an object thereof is to provide a piezoelectric/electrostrictive film type device in which there is not any dielectric breakdown or short-circuit even under a high-humidity environment without reducing flexural displacement of a piezoelectric/electrostrictive layer.

As a result of intensive studies to solve the problem, the present inventors have found that an outer surface of the piezoelectric/electrostrictive layer is modified to form the surface having a desired high water repellency and that the above-described problem can accordingly be solved, and have completed the present invention based on this finding.

That is, according to the present invention, there is provided a piezoelectric/electrostrictive film type device comprising: a substrate formed of a ceramic, and a piezoelectric/electrostrictive operation portion in which at least one piezoelectric/electrostrictive layer and at least one pair of electrodes electrically connected to the piezoelectric/electrostrictive layer are stacked on the substrate, wherein a highly water repellent surface is formed on at least one of outer surface of the piezoelectric/electrostrictive layer and an upper electrode of said at least one pair of electrodes. According to the present invention, there is further provided a piezoelectric/electrostrictive film type device, wherein said highly water repellent surface is modified in such an extent that infiltration of moisture into micro-pores opened in at least one of the outer surface of the piezoelectric/electrostrictive layer and the upper electrode of said at least one pair of electrodes, and/or into a gap between the substrate and the piezoelectric/ electrostrictive layer is sufficiently inhibited.

### BRIEF DESCRIPTION OF DRAWINGS

FIG. 1 is a partially sectional view showing one embodiment of the present invention;
FIG. 2 is a partially sectional view showing another embodiment of the present invention;
FIG. 3 is a partially sectional view showing still another embodiment of the present invention;
FIG. 4 is a partially sectional view showing one embodiment of a multilayered piezoelectric/electrostrictive film type device according to the present invention;
FIG. 5 is a partially sectional view showing another embodiment of the multilayered piezoelectric/electrostrictive film type device according to the present invention;
FIG. 6 is a partially sectional view showing still another embodiment in the multilayered piezoelectric/electrostrictive film type device of the present invention;
FIG. 7 is a partially enlarged view showing the piezoelectric/electrostrictive film type device shown in FIG. 1;
FIG. 8 is a partially enlarged view of the piezoelectric/electrostrictive film type device shown in FIG. 4;
FIG. 9 is a partially enlarged sectional view showing another embodiment of the present invention;
FIG. 10 is a partially enlarged sectional view showing still another embodiment of the present invention;
FIG. 11 is a sectional view showing one example of arrangement of electrodes in the piezoelectric/electrostrictive film type device of the present invention;
FIG. 12 is a top plan view of the piezoelectric/electrostrictive film type device shown in FIG. 11;
FIG. 13 is a sectional view showing another example of the arrangement of the electrodes in the piezoelectric/electrostrictive film type device of the present invention;
FIG. 14 is a sectional view showing still another example of the arrangement of the electrodes in the piezoelectric/electrostrictive film type device of the present invention;
FIG. 15 is a sectional view showing still further example of the arrangement of the electrodes in the piezoelectric/electrostrictive film type device of the present invention;
FIG. 16 is a partially sectional view showing a portion in which a micro-pore is formed in the piezoelectric/electrostrictive film type device of the present invention;
FIG. 17 is a partially sectional view showing a gap formed between the piezoelectric/electrostrictive layer and substrate in the piezoelectric/electrostrictive film type device of the present invention;
FIG. 18 is a sectional view showing one example of a display device using the piezoelectric/electrostrictive film type device of the present invention;
FIG. 19 is a sectional view showing one example of an ink jet printer head using the piezoelectric/electrostrictive film type device of the present invention; and
FIG. 20 is a partially sectional view showing one example of a conventional piezoelectric/electrostrictive film type device.

### DESCRIPTION OF PREFERRED EMBODIMENTS

Embodiments of a piezoelectric/electrostrictive film type device according to the present invention will concretely be described hereinafter, but the present invention is not considered to be limited to these embodiments in any means. The present invention can variously be altered, modified, or improved based on knowledge of a person skilled in the art without departing from the scope of the present invention.

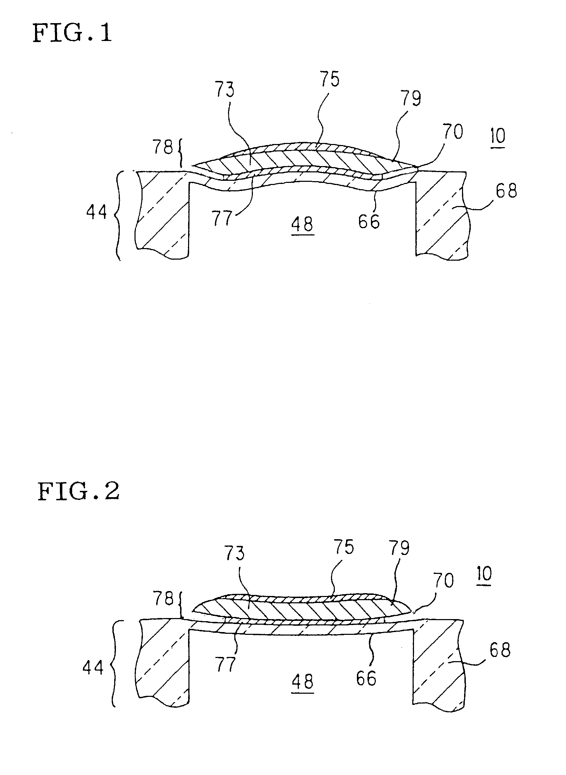

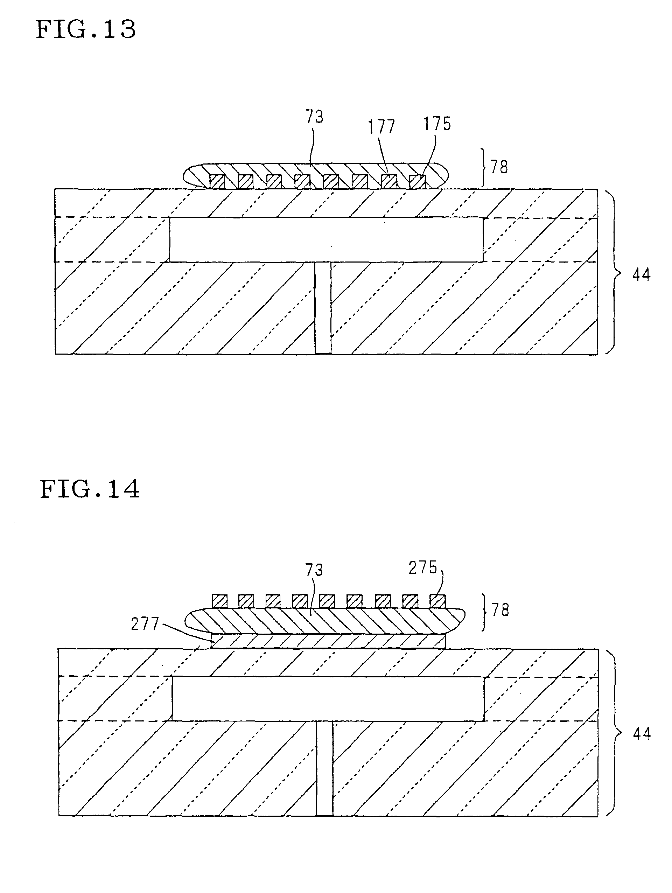

As shown in FIGS. 1 to 10, a piezoelectric/electrostrictive film type device 10 of the present invention includes a piezoelectric/electrostrictive operation portion 78 in which at least one piezoelectric/electrostrictive layer 73 and at least one pair of electrodes 75, 77 (75 to 77) electrically connected to the piezoelectric/electrostrictive layer 73 are stacked on a substrate 44 formed of a ceramic. Moreover, in the present invention, as shown in FIG. 13, an outer surface of the piezoelectric/electrostrictive layer 73 or the upper electrode 75 obtains a highly water repellent surface for inhibiting moisture 91 from infiltrating into micro-pores 81 opened in the outer surface or a gap 70 between the substrate 44 and piezoelectric/ electrostrictive layer 73 by surface modification.

Accordingly, there can be provided a piezoelectric/electrostrictive film type device in which any moisture does not infiltrate into the micro-pores 81 opened in the outer surface of the piezoelectric/ electrostrictive layer 73 or the upper electrode 75 and there is not any dielectric breakdown or short-circuit of the piezoelectric/electrostrictive layer 73. In the piezoelectric/electrostrictive film type device, the piezoelectric/electrostrictive layer 73 including the projecting portion 79 which does not contact the upper and lower surfaces of the respective electrodes 75, 77 (75 to 77) is disposed. Even in this case, there can be provided the piezoelectric/electrostrictive film type device 10 in which the moisture does not infiltrate into the gap 70 between the piezoelectric/electrostrictive layer 73 and substrate 44 and which is superior in durability without causing any peel of the piezoelectric/electrostrictive layer 73. In addition, for the piezoelectric/electrostrictive film type device 10 of the present invention, only the surface of the piezoelectric/electrostrictive layer 73 is modified.
Therefore, there is hardly restriction onto the piezoelectric/electrostrictive layer, and the above-described effect can be fulfilled without deteriorating the properties of the piezoelectric/electrostrictive layer 73, such as the flexural displacement. Constituting elements will concretely be described hereinafter.

As shown in FIGS. 1 to 6, the substrate 44 in the present invention includes, for example, a structure in which a thin portion 66 having a sheet-like shape is formed integrally with a fixing portion 68 formed of a thick ceramic member. Moreover, in the substrate 44 including this structure, the thin portion 66 having the sheet-like shape is solidly attached to the fixing portion 68 in a position other than a position where the piezoelectric/electrostrictive layer 73 is laid. A cavity 48 is usually disposed opposite to the position where the piezoelectric/electrostrictive layer 73 is laid under the thin portion 66.

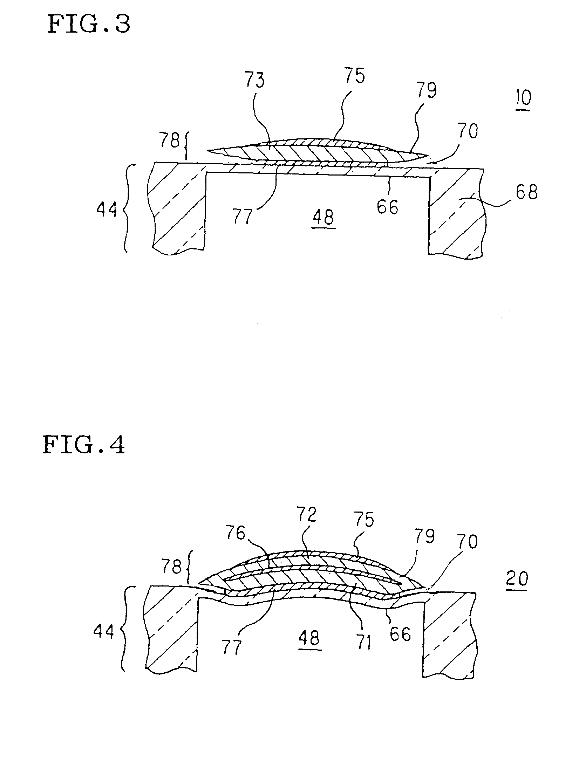

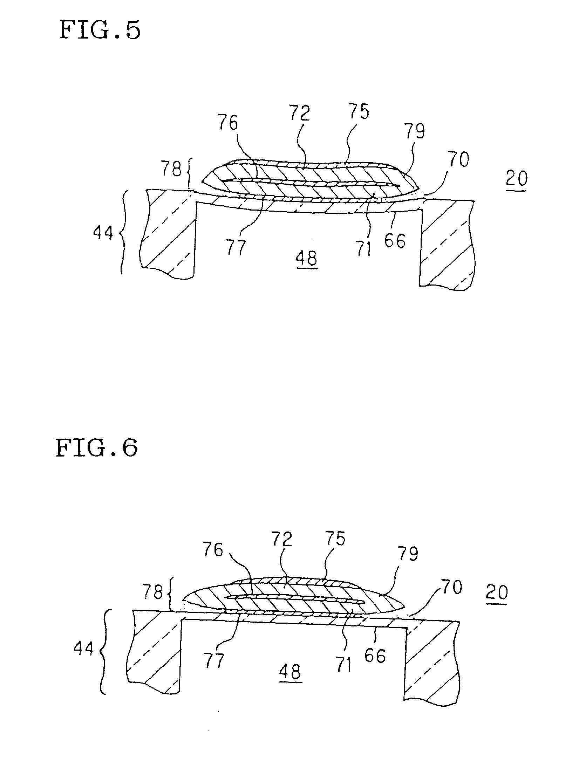

Moreover, as shown in FIGS. 3 and 6, the thin portion 66 may also be formed of a flat plate whose section of a thickness direction is rectangular. The thin portion 66 whose middle portion has a shape bent toward the cavity 48 as shown in FIGS. 2 and 5 or whose section of the thickness direction has a W shape as shown in FIGS. 1 and 4 is preferable in that the flexural displacement is large. The thin portion having the latter W-shaped section is especially preferable.

It is to be noted that the thin portion 66 having the bent shape as shown in FIGS. 2 and 5 or the W shape as shown in FIGS. 1 and 4 can be formed by using shrinkage of a piezoelectric/electrostrictive film in a short direction at a time of a sintering step of the piezoelectric/electrostrictive layer 73, or by adjusting a sintering shrinkage start timing or sintering shrinkage of upper and lower portions of the piezoelectric/electrostrictive layer 73, or further the shape of the thin portion 66.

In the present invention, the thickness of the thin portion 66 is preferably set to such a range that mechanical strength of the device is secured and the flexural displacement of the piezoelectric/electrostrictive layer 73 is further prevented from being deteriorated by an increase of rigidity. Concretely, the thickness is in a range of preferably 1 µm to 50 µm, more preferably 3 to 50 µm, especially preferably 3 to 12 µm. The thickness of the fixing portion 68 is preferably 10 µm or more, more preferably 50 µm or more.

The shape of the surface of the substrate 44 on which the piezoelectric/electrostrictive operation portion 78 is laid is not especially limited to the rectangular shape. The surface may also be formed in a circular shape, or a polygonal shape other than a square shape, such as a triangular shape.

The substrate 44 in the present invention may be formed of the ceramic, but is preferably constituted of a material which does not change in properties at a time of a heating treatment of the piezoelectric/electrostrictive layer 73 or the electrodes 75, 77 stacked on the thin portion 66 and which is superior in heat resistance and chemical stability. The substrate 44 is preferably formed of an electric insulation material so that a wiring connected to the lower electrode 77 formed on the substrate 44 is electrically disconnected.

Concretely, examples of the material include at least one material selected from a group consisting of (stabilized) zirconium oxide, aluminum oxide, magnesium oxide, titanium oxide, cerium oxide, spinel, mullite, aluminum nitride, silicon nitride, and glass. Above all, the material containing stabilized zirconium oxide is preferable in that the mechanical strength is high, tenacity is superior, and the durability of the thin portion 66 including a thin structure and loaded with vibration can therefore be improved, and that chemical stability is high and reactivity with the piezoelectric/electrostrictive layer 73 or the electrodes 75, 77 is remarkably small.

Moreover, examples of stabilized zirconium oxide may contain stabilizers such as calcium oxide, magnesium oxide, yttrium oxide, scandium oxide, ytterbium oxide, cerium oxide, and rare earth metal oxide. For an amount of the stabilizer, the amount of yttrium oxide or ytterbium oxide is preferably 1 to 30 mol%, more preferably 1.5 to 10 mol%. The amount of cerium oxide is preferably 6 to 50 mol%, more preferably 8 to 20 mol%. The amount of calcium oxide or magnesium oxide is preferably 5 to 40 mol%, more preferably 5 to 20 mol%.

Furthermore, among these stabilizers, yttrium oxide is especially preferably added in an amount of preferably 1.5 to 10 mol%, especially preferably 2 to 4 mol%.

Additionally, the thin portion 66 may contain the ceramic as described above, and further contain components such as silicon oxide or boron oxide contained in clay for use as a sintering aid. However, when these components are excessively contained, it is difficult to maintain a specific composition of the piezoelectric/electrostrictive layer 73 by reaction between the substrate 44 and piezoelectric/electrostrictive layer 73, and this is a cause for deterioration of piezoelectric/electrostrictive properties. Therefore, for the thin portion 66 of the substrate 44 in the present invention, silicon oxide or boron oxide contained in clay is in a range of preferably 20% or less by mass, more preferably 3% or less by mass in the thin portion 66.

Furthermore, the ceramic constituting the thin portion 66 has an average particle diameter of crystal grains in a range of preferably 0.05 to 2 µm, more preferably 0.1 to 1 µm in order to enhance the mechanical strength of the thin portion 66.

Next, as shown in FIGS. 1 to 6, 11 to 15, the electrodes 75, 77 (75 to 77) in the present invention are electrically connected to the piezoelectric/electrostrictive layer 73 (71, 72). As a typical example, as shown in FIGS. 1 to 3, a pair of flat film shaped electrodes 75, 77 may be stacked on the upper and lower surfaces of the piezoelectric/electrostrictive layer 73.

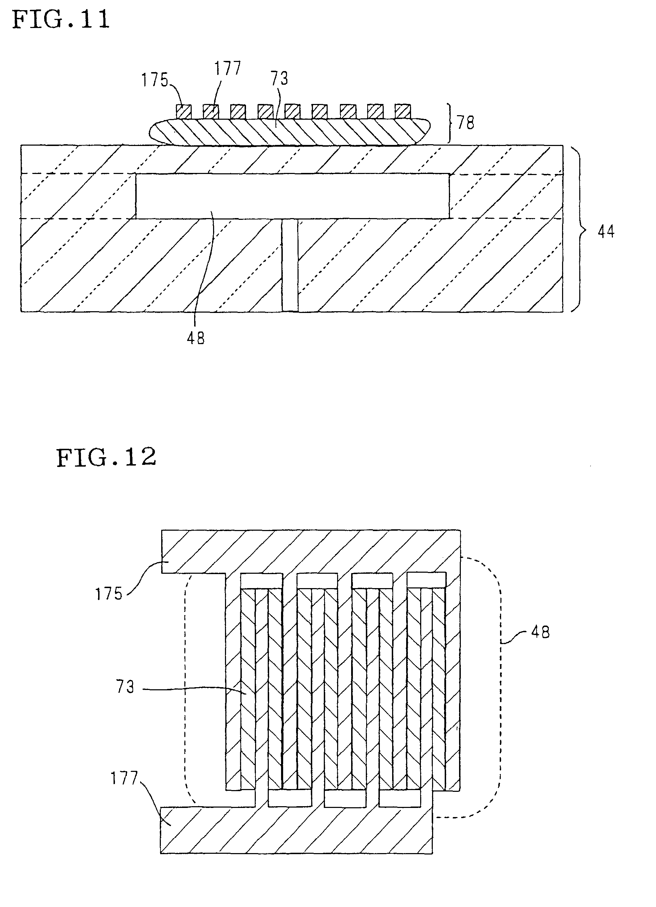

Moreover, modification examples include one pair of comb-shaped electrodes 175, 177 formed on the upper surface of the piezoelectric/electrostrictive layer 73 as shown in FIGS. 11 and 12, and one pair of comb-shaped electrodes 175, 177 formed the lower surface of the piezoelectric/electrostrictive layer 73 as shown in FIG. 13.

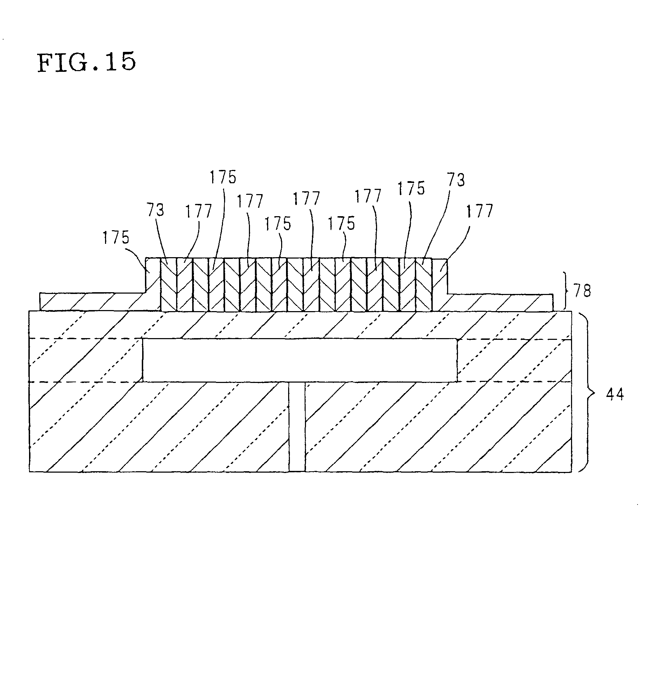

Furthermore, as shown in FIG. 14, a single flat film shaped electrode 277 is formed in the lower surface of the piezoelectric/electrostrictive layer 73, and a plurality of band-shaped electrodes 275 are formed in the upper surface of the piezoelectric/electrostrictive layer 73. Alternatively, as shown in FIG. 15, one pair of comb-shaped electrodes 175, 177 are embedded in the piezoelectric/electrostrictive layer 73, and the respective electrodes 175, 177 are alternately disposed in a plurality of segments of the piezoelectric/electrostrictive layer 73 divided in a field direction.

Additionally, in the present invention, there can be provided a multilayered piezoelectric/electrostrictive film type device 20 as shown in FIGS. 4 to 6. In this case, a plurality of piezoelectric/electrostrictive layers 71, 72 and electrodes 75 to 77 are disposed, and the respective electrodes 75 to 77 are preferably alternately held between the piezoelectric/electrostrictive layers 71, 72 to constitute the piezoelectric/electrostrictive film type device.

Moreover, in the present invention, the piezoelectric/electrostrictive film type device shown in FIGS. 11 to 14 has an advantage that power consumption can be reduced. The piezoelectric/electrostrictive film type device shown in FIG. 15 includes a structure in which an inverse piezoelectric effect of the field direction large in strain and generation force can effectively be used, and is advantageous in causing large displacement.

In the present invention, the thicknesses of the electrodes 75, 77 (75 to 77) shown in FIG. 1 are set to be appropriate in accordance with applications. However, if the thickness is excessively large, the electrodes function as a relaxation layer. Since the flexural displacement tends to be reduced, the thickness is preferably 15 µm or less, more preferably 5 µm or less.

Moreover, the electrodes 75, 77 (75 to 77) are preferably formed of materials which are solid at room temperature and which can withstand a high-temperature oxidation atmosphere at a time of sintering and integrating the electrodes and the substrate and/or the piezoelectric/electrostrictive layer and which is superior in electric conductivity. Concrete examples of the materials include aluminum, titanium, chromium, iron, cobalt, nickel, copper, zinc, niobium, molybdenum, ruthenium, palladium, rhodium, silver, tin, tantalum, tungsten, iridium, platinum, gold, lead, and another simple metal or an alloy containing one of the metals mentioned above. A cermet material may also be used in which the materials constituting the piezoelectric/electrostrictive layer, or the material constituting the substrate 44 such as zirconium oxide, cerium oxide, and titanium oxide are dispersed in the metals described above.

Moreover, the materials of the electrodes 75, 77 (75 to 77) in the present invention are preferably selected in consideration of a method of forming the piezoelectric/electrostrictive layer 73 (71, 72). For example, for the piezoelectric/electrostrictive film type device 10 shown in FIGS. 1 to 3, at a time of the heating treatment of the piezoelectric/electrostrictive layer 73, in the lower electrode 77 already formed on the substrate 44, it is preferable to use a simple metal of a platinum group which does not change even at a heating treatment temperature of the piezoelectric/electrostrictive layer 73, an alloy of the simple metal of the platinum group and gold and/or silver, an alloy of the platinum group metals, an alloy of two or more different types of metals of the platinum group, or high-melting metals such as an alloy of the metals of the platinum group and gold and/or silver. Also in the piezoelectric/electrostrictive film type device 20 including the multilayered structure shown in FIGS. 4 to 6, it is preferable to use the high-melting metals in the electrode 77 positioned in a lowermost layer and an intermediate electrode 76 disposed between the piezoelectric/electrostrictive layers 71, 72, which are already formed at the time of the heating treatment of the piezoelectric/electrostrictive layers 71, 72.

On the other hand, in the piezoelectric/ electrostrictive film type device 10 shown in FIGS. 1 to 3, after the heating treatment of the piezoelectric/electrostrictive layer 73, the upper electrode 75 can be formed on the piezoelectric/electrostrictive layer 73 at a low temperature (the electrode 75 positioned in an uppermost layer in the multilayered piezoelectric/electrostrictive film type device 20 shown in FIGS. 4 to 6). Therefore, in addition to the high-melting metals, low-melting metals such as aluminum, gold, and silver may also be used.

Moreover, in the multilayered piezoelectric/electrostrictive film type device shown in FIGS. 4 to 6, the electrode 77 positioned in the lowermost layer, and the intermediate electrode 76 disposed between the piezoelectric/electrostrictive layers 71, 72 are also preferably constituted of electrode materials which contain platinum as a major component and further contain additives such as zirconium oxide, cerium oxide, and titanium oxide. Although reasons are unclear, the electrodes and piezoelectric/electrostrictive device constituted of these materials can be prevented from peeling. Moreover, the additives are preferably contained in all the electrode materials in an amount of 0.01 to 20% by mass in that a desired peel preventive effect is obtained.

It is to be noted that examples of the method of forming the electrodes include ion beam, sputtering, vacuum deposition, PVD, ion plating, CVD, plating, screen printing, spraying, and dipping.

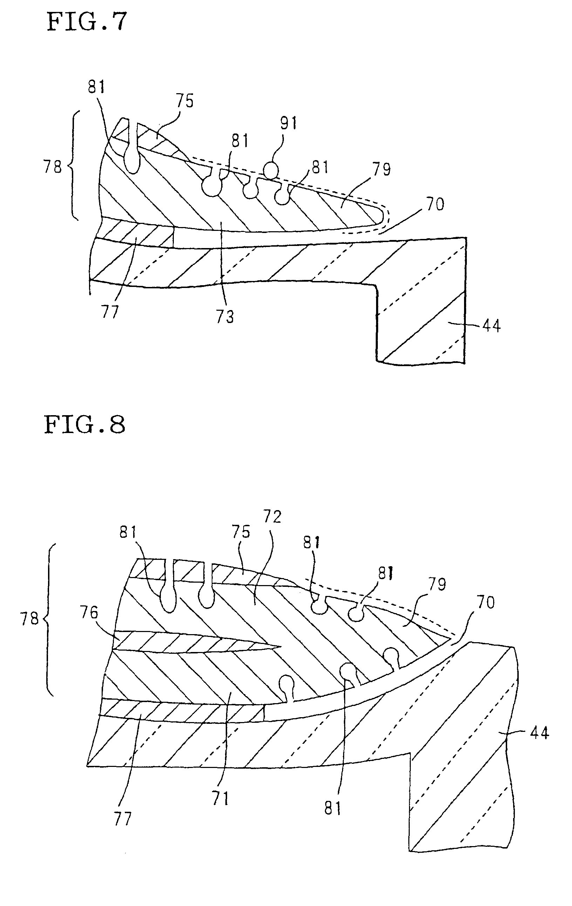

Next, as shown in FIGS. 7 to 10, 16, 17, in the piezoelectric/electrostrictive layer 73 of the present invention, by the surface modification, the outer surface of the piezoelectric/electrostrictive layer 73 includes a highly water repellent surface for inhibiting the moisture 91 from infiltrating into the micro-pores 81 opened in the outer surface, or the gap 70 between the substrate 44 and the piezoelectric/electrostrictive layer 73 (71, 72).

Here, "the surface modification" in the present specification means that the ceramic or metal constituting the piezoelectric/electrostrictive layer or electrode and existing in the outer surface of the piezoelectric/electrostrictive layer or electrode changes into a chemical structure in which water repellency increases. Since the ceramic or metal constituting the piezoelectric/electrostrictive layer or electrode is not physically shielded from outside air, the outer surface is based on a concept different from that of a coat for physically shielding the ceramic or metal constituting the piezoelectric/electrostrictive layer from the outside air. It is to be noted that in FIGS. 7 to 10, portions subjected to the surface modification are shown by broken lines.

In the present invention, examples of the piezoelectric/electrostrictive layer 73 (71, 72) or electrode 75 subjected to the surface modification include a structure in which a fluorine-based polymer compound is chemically bonded to the ceramic or metal constituting the piezoelectric/electrostrictive layer and fluorine elements are arranged in the surface of the piezoelectric/electrostrictive layer or electrode.

In the present invention, the surface modification can be performed, for example, by coating the surface of the piezoelectric/electrostrictive layer 73 or electrode 75 with a surface modifier containing the fluorine-based polymer compound as the major component to chemically bond the fluorine-based polymer compound to the ceramic or metal.

Moreover, examples of the surface modifier for use in this case include: the fluorine-based polymer compound dissolved in hydrofluoroether; the fluorine-based polymer compound dissolved in hydrofluoroether and further mixed with dispersed polytetrafluoroethylene (PTFE); a silicone solution containing metaxylene hexafluoride as the major component; an acetic ether solution of 3, 3, 3-trifluoropropyl trimethoxysilane and the fluorine-based polymer compound. Of these, the fluorine-based polymer compound dissolved in hydrofluoroether is preferable in that the water repellency is good. The fluorine-based polymer compound dissolved in hydrofluoroether and further mixed with dispersed polytetrafluoroethylene (PTFE) is more preferable in that the water repellency is good.

Moreover, for the surface modifier of the fluorine-based polymer compound dissolved in hydrofluoroether, or the surface modifier of the fluorine-based polymer compound dissolved in hydrofluoroether and further mixed with dispersed polytetrafluoroethylene (PTFE), a solid content concentration of the fluorine-based polymer compound is preferably 0.1 to 10%, more preferably 0.2 to 5%, further preferably 1 to 4%, and especially preferably 2 to 3% in that diffusive properties of the surface modifier at a coating time are superior and a water repellent effect is great after the surface modification.

It is to be noted that the surface modifier for use in the present invention may be colorless/transparent, but may also be mixed with a colorant and preferably colored in order to securely identify a region subjected to the surface modification.

Moreover, examples of a commercially available surface modifier preferably include: RFH-01 manufactured by Hishie Kagaku Kabushiki Kaisha (the solid content concentration of the fluorine-based polymer compound: 2%); RFH-02 manufactured by Hishie Kagaku Kabushiki Kaisha (the solid content concentration of the fluorine-based polymer compound: 1%); RFH-10 manufactured by Hishie Kagaku Kabushiki Kaisha (the solid content concentration of the fluorine-based polymer compound: 0.2%); RFH-10R manufactured by Hishie Kagaku Kabushiki Kaisha (the solid content concentration of the fluorine-based polymer compound: 0.3%, containing the colorant); PTFE grade = RFH-10R manufactured by Hishie Kagaku Kabushiki Kaisha (the solid content concentration of the fluorine-based polymer compound: 1.2%); a silicone solution KP-801M manufactured by Shin-Etsu Chemical Co., Ltd. (95% or more of metaxylene hexafluoride); organo-silane KBM-7103 manufactured by Shin-Etsu Chemical Co., Ltd.; and CT-301S-2 manufactured by Kabushiki Kaisha Asahi Kagaku Kenkyusho.

Moreover, in a method of the surface modification in the present invention, the portion including at least the piezoelectric/electrostrictive layer may be coated with the above-described surface modifier. Examples of the coating method at this time include a spin coating method, dipping method, brush coat method, dispenser method, and ink jet method.

Furthermore, to apply the surface modifier by the spin coating method, for example, for the piezoelectric/electrostrictive film type device, the surface of the substrate on a side opposite to the surface in which the piezoelectric/electrostrictive layer is disposed is covered with a UV sheet lest any portion of the surface modifier should not stick thereon as a result of spreading throughout from the coated portion. In this state, the device is fixed to a sample stage. Immediately after the surface modifier is dropped onto the surface of the piezoelectric/electrostrictive film type device, the number of rotations of the sample stage is raised to 1000 to 3000 rpm, and the stage may be rotated for about ten seconds to five minutes. To apply the surface modifier by the brush coat method, after assembling wirings and components, the surface of the piezoelectric/electrostrictive device may be coated with the surface modifier with a brush. It is to be noted that the surface modifier for use in the present invention usually has a very small surface tension in the surface of the piezoelectric/electrostrictive layer. In the above-described coat method, the surface modifier naturally infiltrates into the micro-pores opened in the surface of the piezoelectric/electrostrictive layer, or into the gap between the piezoelectric/electrostrictive layer and the substrate. In the present invention, when the device is left to stand for ten or more minutes at room temperature after the coating with the modifier and dried by natural drying, the modification treatment of the surface properties is completed.

It is to be noted that in the coating with an excess amount of the surface modifier, a coat is sometimes formed in the piezoelectric/electrostrictive layer, substrate, or electrode. Therefore, after applying the surface modifier, the excessive surface modifier is preferably removed. In this respect, the spin coating method is preferable, because the excessive surface modifier can be removed by a rotation force at the time of the coating with the surface modifier. Needless to say, also in the brush coat method, after the coating with the surface modifier, compressed air may also be sprayed to remove the excessive surface modifier.

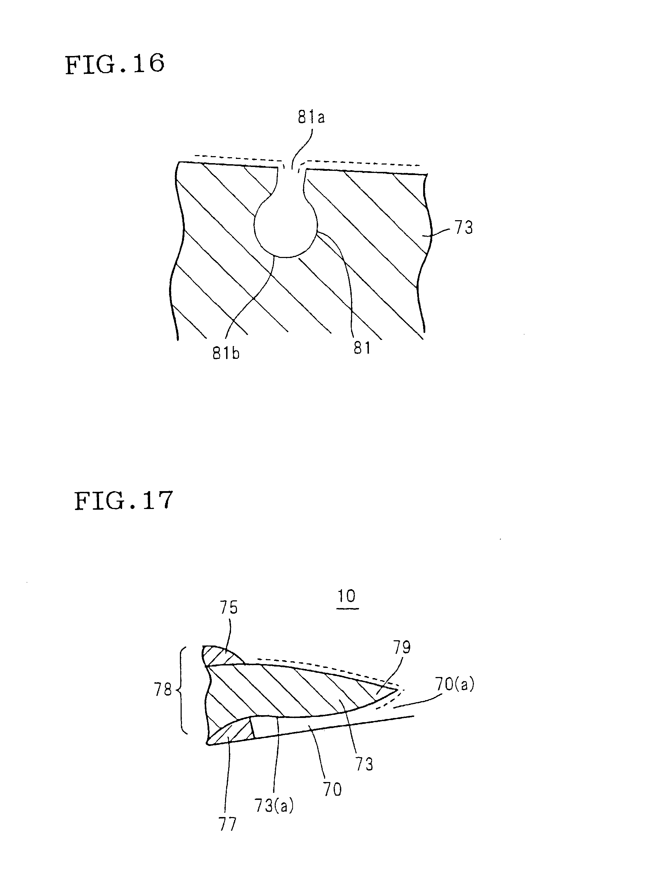

In the surface modification in the present invention, the outer surface of the piezoelectric/electrostrictive layer 73 or electrode 75 is modified into the highly water repellent surface. The surface modification may be performed to such an extent that the moisture 91 is inhibited from infiltrating into the micro-pores 81 opened in the outer surface of the piezoelectric/electrostrictive layer 73 or electrode 75, or into the gap (non-bonded portion) 70 between the substrate 44 and piezoelectric/electrostrictive layer 73. Concretely, it is not necessarily necessary to modify the whole outer surface of the piezoelectric/electrostrictive layer 73 or electrode 75 including the inner surfaces of the micro-pores 81 opened in the outer surface of the piezoelectric/electrostrictive layer 73 or electrode 75. For example, as shown in FIG. 16, when the surface in the vicinity of an opening 81a of the micro-pore 81 in the piezoelectric/electrostrictive layer 73 or electrode 75 is modified, the surface extending to a bottom 81b of the micro-pore does not have to be modified. Similarly, as shown in FIG. 17, for the piezoelectric/electrostrictive film type device 10 in which the piezoelectric/electrostrictive layer 73 including the projecting portion 79 is disposed, when the surface in the vicinity of an opening 70a of the gap 70 between the substrate 44 and piezoelectric/electrostrictive layer 73 in the piezoelectric/electrostrictive layer 73 is modified, a piezoelectric/electrostrictive layer portion 73a forming the gap 70 from the substrate 44 does not have to be entirely modified. Needless to say, to more securely avoid the infiltration of the moisture, the whole outer surface of the piezoelectric/electrostrictive layer 73 including the inner surface of the micro-pore 81 opened in the outer surface of the piezoelectric/electrostrictive layer 73 is preferably modified.

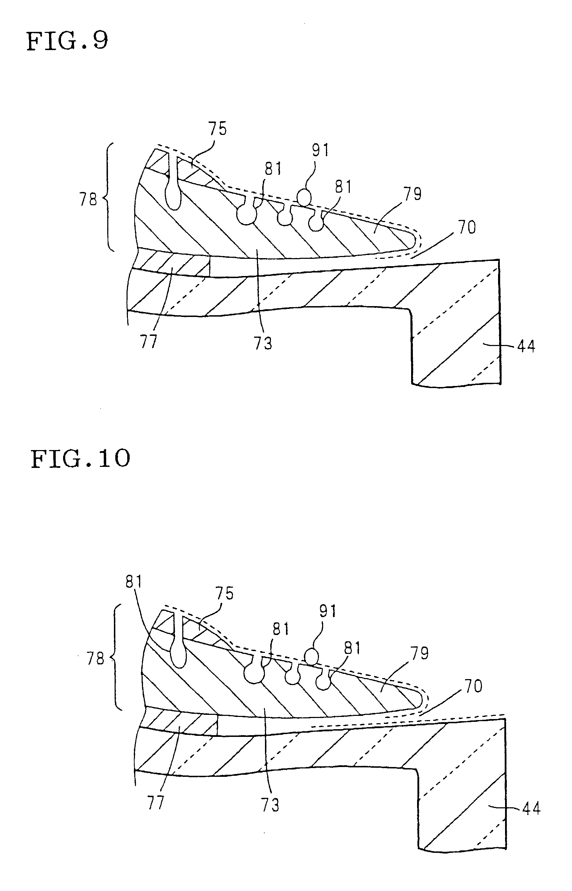

Moreover, in the present invention, as shown in FIGS. 7, 8, only the piezoelectric/electrostrictive layer 73 (71, 72) or the electrode 75 may be subjected to the surface modification (the drawings show that only the piezoelectric/electrostrictive layer is subjected to the surface modification). Additionally, as shown in FIG. 9, one of the micro-pores 81 reaches the piezoelectric/ electrostrictive layer through the electrode. Therefore, to more securely prevent the dielectric breakdown, not only the piezoelectric/electrostrictive layer 73 but also the upper electrode 75 are preferably subjected to the surface modification. As shown in FIG. 10, the surface of the substrate 44 in which the piezoelectric/electrostrictive layer is laid is further modified. In this case, weather resistances (moisture resistance, light resistance, acid resistance, contamination resistance) of the device can be enhanced, and the moisture can preferably be inhibited from infiltrating between the substrate 44 and the piezoelectric/electrostrictive layer 73.

In the present invention, the piezoelectric/electrostrictive layer 73 may not necessarily include the projecting portion 79 shown in FIGS. 1 to 6, but the projecting portion 79 is preferably disposed so as to secure the insulation between the electrodes. When the piezoelectric/electrostrictive layer 73 including the projecting portion 79 is disposed, the projecting portion 79 may completely be detached from the substrate, or may partially be bonded to the substrate. It is to be noted that as described above, needless to say, the present invention can especially preferably be applied to the piezoelectric/electrostrictive film type device 10 in which the piezoelectric/electrostrictive layer 73 including the projecting portion 79 is disposed.

In the present invention, the material of the piezoelectric/electrostrictive layer 73 (71, 72) may be crystalline or amorphous as long as field inducing strains such as piezoelectric or electrostrictive effects are caused. Any of a semiconductor, ceramic, ferroelectric ceramic, and antiferroelectric ceramic may be used, and the material may appropriately be selected/used in accordance with the application.

Concrete examples of the material include the ceramic containing one or two or more of lead zirconate, lead titanate, lead zirconate titanate, lead magnesium niobate, lead nickel niobate, lead zinc niobate, lead manganese niobate, lead antimony stannate, lead manganese tungstate, lead cobalt niobate, barium titanate, sodium bismuth titanate, potassium sodium niobate, and strontium bismuth tantalite. Especially, a material containing lead zirconate titanate (PZT-system) and lead magnesium niobate (PMN-system) as the major components, or sodium bismuth titanate as the major component is especially preferable, in that stabilized composition having a high electromechanical coupling coefficient and piezoelectric constant and little reactivity with the ceramic substrate at the sintering time of the piezoelectric/electrostrictive film is obtained.

Furthermore, a material may also be used including the ceramic material containing a small amount of components to which at least one alone or two or more oxides of lantern, calcium, strontium, molybdenum, tungsten, barium, niobium, zinc, nickel, manganese, cerium, cadmium, chromium, cobalt, antimony, iron, yttrium, tantalum, lithium, bismuth, and tin are added. For example, when lantern or strontium is contained in lead zirconate, lead titanate, and lead magnesium niobate as the major components, advantages can sometimes be obtained that anti-electric field or piezoelectric property can be adjusted.

In the present invention, the thickness of the piezoelectric/electrostrictive layer 73 shown in FIGS. 1, and the like is preferably set to be substantially equal to that of the substrate 44 in that the mechanical strength and desired flexural displacement of the device can be secured. Concretely, a ratio of the thickness to that of the thin portion 66 of the substrate 44 (the thin portion/(the piezoelectric/electrostrictive layer)) is preferably 0.1 to 30, more preferably 0.3 to 10, and especially preferably 0.5 to 5.

When the ratio of the thickness to that of the substrate 44 (the thin portion of the substrate/the piezoelectric/electrostrictive layer) is in this range, the substrate 44 (the thin portion 66) easily follows the sintering shrinkage of the piezoelectric/electrostrictive layer 73 at a time of the coating of the substrate 44 with the piezoelectric/ electrostrictive material and the subsequent heating treatment for forming the piezoelectric/electrostrictive layer 73. The substrate can be integrated with the dense piezoelectric/electrostrictive layer 73 without causing the peel. A sufficient resistance to the vibration by the bending of the piezoelectric/electrostrictive layer 73 can be imparted.

Needless to say, for the thickness of the piezoelectric/electrostrictive layer 73, in order to realize the miniaturization of the device, the thickness is preferably 5 to 100 µm, more preferably 5 to 50 µm, and especially preferably 5 to 30 µm.

Moreover, in the multilayered piezoelectric/electrostrictive film type device 20 shown in FIGS. 4 to 6, the piezoelectric/electrostrictive film type device is formed in a thin film shape. Then, an aspect ratio can be raised. In this respect, the thickness per layer in the piezoelectric/electrostrictive layers 71, 72 is preferably set to 30 µm or less. Furthermore, a plurality of piezoelectric/electrostrictive layers 71, 72 are preferably formed so that the layers gradually become thin in order from the lower layer. For example, the layers are preferably formed so that a thickness tₙ of an n-th piezoelectric/electrostrictive layer from below satisfies the following equation: tₙ ≤ tₙ₋₁×0.95. The strain of the piezoelectric/electrostrictive layer is large at the same driving voltage, when the piezoelectric/electrostrictive layer has a small thickness. Therefore, the upper piezoelectric/electrostrictive layer is formed so that the layer is strained more than the lower piezoelectric/electrostrictive layer. Accordingly, a bending efficiency is improved, and the flexural displacement can more effectively be developed.

To obtain the piezoelectric/electrostrictive layer 73 in the present invention, for example, after the piezoelectric/electrostrictive material including the above-described ceramic material is stacked on the lower electrode 77 formed in the substrate 44 (after each of the piezoelectric/electrostrictive layers 71, 72 is stacked or after all of the piezoelectric/electrostrictive layers 71, 72 are stacked in the multilayered piezoelectric/electrostrictive device 20 shown in FIGS. 4 to 6), a heat treatment is performed at a predetermined temperature.

The piezoelectric/electrostrictive material for use in the present invention can be prepared, for example, by an oxide mixing method, coprecipitation method, alcoxide method, and the like.

Moreover, examples of the method of applying the piezoelectric/electrostrictive material include: various thick-film forming methods such as a screen printing method, dipping method, coat method, and electrophoretic migration method; and various thin-film forming methods such as an ion beam method, sputtering method, vacuum deposition method, ion plating method, chemical vapor deposition method (CVD), and plating. Above all, since the piezoelectric/electrostrictive layer 73 having satisfactory piezoelectric/electrostrictive properties is obtained, the thick-film forming methods such as the screen printing method, dipping method, coat method, and electrophoretic migration method are preferable.

It is to be noted that to dispose the projecting portion 79, the piezoelectric/electrostrictive material may be printed or applied in a broader range so as to coat the upper and lower surfaces of the respective electrodes. In this case, for example, when a material having little reactivity with the piezoelectric/electrostrictive materials such as zirconium oxide at the heating treatment time is selected as the material of the substrate, the projecting portion 79 of the piezoelectric/electrostrictive layer can be set to a completely non-bonded state with respect to the substrate 44.

Moreover, when the multilayered piezoelectric/electrostrictive film type device 20 shown in FIGS. 4 to 9 is formed, for example, the electrode 77 is stacked on the substrate 44, thereafter the piezoelectric/electrostrictive materials are stacked alternately with the plurality of electrodes 75, 76 by the above-described various methods, and finally the electrode 75 may be disposed.

In the present invention, after forming the piezoelectric/electrostrictive material on the lower electrode 77 (after stacking each piezoelectric/electrostrictive material in the lowermost layer, or between the electrodes positioned in the intermediate layer in the multilayered piezoelectric/electrostrictive film type device 20 shown in FIGS. 4, and the like, or after stacking all the necessary layers of the piezoelectric/electrostrictive materials), the heating treatment may be performed at a temperature of 1000 to 1400°C. In this case, in order to prevent evaporation of each component in the piezoelectric/electrostrictive material and to obtain a ceramic composite having a predetermined composition, it is preferable to also dispose an atmosphere-controlling material having the same composition as that of the piezoelectric/electrostrictive material.

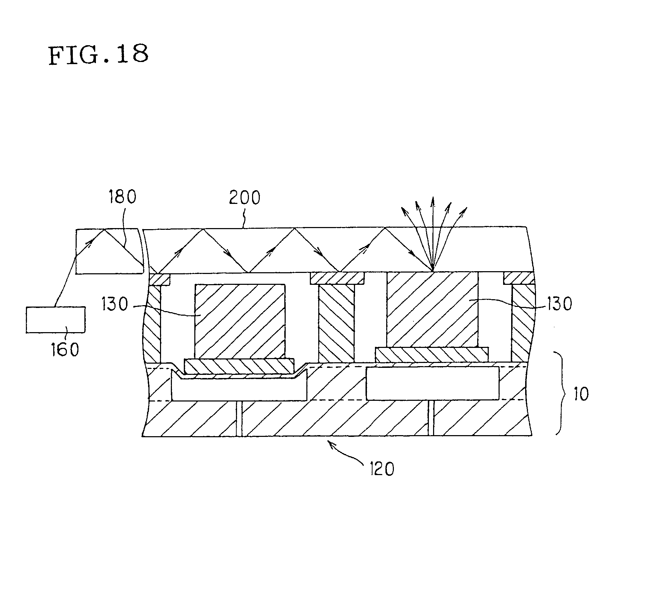

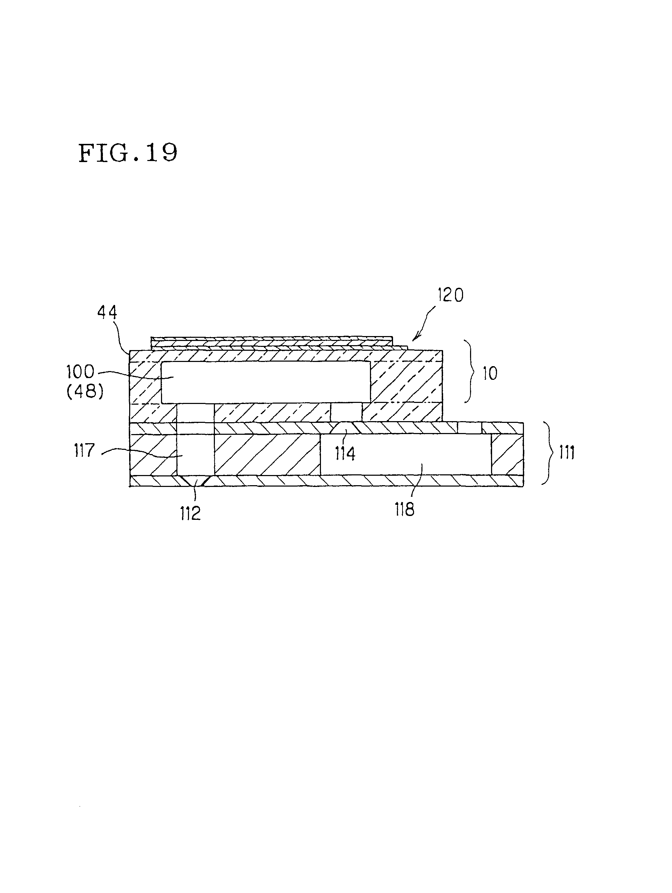

The piezoelectric/electrostrictive film type device and the manufacturing method of the device according to the present invention have been described above, but the piezoelectric/electrostrictive film type device of the present invention can be used, for example, as a driving portion 120 of a display device or ink jet printer head as shown in FIGS. 18, 19. Concretely, as shown in FIG. 18, a light guide plate 200 for introducing a light 180 from a light source 160 is disposed. Additionally, the driving portion 120 including the piezoelectric/electrostrictive film type device 10 of the present invention as a main constituting element is disposed opposite to the rear surface of the light guide plate 200, and opposite to a pixel. Furthermore, pixel constituting materials 130 are stacked on the driving portion 120, and the pixel constituting materials 130 can be connected to or disconnected from the light guide plate 200 by a driving operation of the driving portion 120 to constitute the display device. Moreover, as shown in FIG. 19, the driving portion 120 including the piezoelectric/electrostrictive film type device 10 of the present invention as the main constituting element and including a pressurizing chamber 100 constituted of the cavity 48 of the substrate 44 is integrally bonded to an ink nozzle member 111 including a nozzle 112 opened to the outside from the pressurizing chamber 100 of the driving portion 120 through a channel for ink jet 117, and an orifice 114 opened into the pressurizing chamber 100 of the driving portion 120 from an ink supply source through a channel for ink supply 118. Accordingly, the ink jet printer head can be constituted. For the concrete constitution of the display device or the ink jet printer head, the contents of JP-A-2001-343598 and JP-A-11-147318 are incorporated herein by reference.

(Example) The present invention will concretely be described hereinafter by examples of a piezoelectric film type device, but the present invention is not limited to these examples. It is to be noted that evaluation was performed as follows with respect to each example and comparative example.

### (Evaluation Method)

### (1) Flexural Displacement

An electric field of 3 kV/mm was applied to each piezoelectric film type device obtained in each example or comparative example at room temperature. The resulting displacement was measured using a laser Doppler vibration meter.

### (2) Insulation Test

A bath having a constant temperature and humidity was used to evaluate insulation resistance at an application time of direct current of 40 V at a temperature of 27°C and humidity of 90%.

### (3) Water Repellency

Pure water was dropped, and the water repellency was visually confirmed.

### (Example 1)

A platinum-made lower electrode (dimension: 1.2×0.8 mm, thickness: 3 µm) was formed on a substrate whose thin portion and fixing portion were both made of Y₂O₃-stabilized ZrO₂ (dimension of the thin portion: 1.6×1.1 mm, thickness: 10 µm) by the screen printing method. The heat treatment at a temperature of 1300°C for 2 hours was carried out to integrate the electrode with the substrate.

Thereon, a piezoelectric material constituted of ( Pb_{0·999}La_{0·001} ) (Mg_{1/3}Nb_{2/3} )_{0.375}Ti_{0.375}Zr_{0·250}O₃ in which a part of Pb was substituted with 0.1 mol% of La (average particle diameter of 0.49 µm, maximum particle diameter of 1.8 µm) was laminated in a thickness of 20 µm in a broader range of 1.3×0.9 mm including the surface disposed opposite to the upper surface of the lower electrode by the screen printing method.

Subsequently, the atmosphere-controlling material having the same composition as that of the piezoelectric material was placed in a container, and the laminate of the piezoelectric material on the electrode-formed substrate was heat-treated at 1275°C for two hours. The thickness of the piezoelectric layer after the heat treatment was 13 µm.

Subsequently, the upper electrode of gold was formed in a thickness of 0.5 µm in a range of 1.2×0.8 mm on the piezoelectric layer by the screen printing method, and heat-treated at 60°C.

Subsequently, a portion of the obtained device on a side opposite to a surface of the substrate in which the piezoelectric/electrostrictive layer and electrode were disposed was covered with a UV sheet lest any portion of the surface modifier should not stick thereon as a result of spreading throughout from the coated portion and fixed onto a sample stage. The whole device was coated with the surface modifier of the fluorine-based polymer compound dissolved in hydrofluoroether (RFH-01 manufactured by Hishie Kagaku Kabushiki Kaisha (the solid content concentration of the fluorine-based polymer compound: 2%) by the spin coating method. In this case, immediately after dropping the coat solution, the rotation number was increased to 2000 rpm, and the sample stage was rotated for 30 seconds.

Finally, after stopping the rotation, the device coated with the surface modifier was left to stand at room temperature for 10 minutes. Thereafter, the surfaces of the piezoelectric/electrostrictive layer, substrate, and upper electrode were subjected to the modification treatment. Accordingly, the piezoelectric/electrostrictive film type device having a high water repellency was manufactured.

When the piezoelectric/electrostrictive layer surface of the obtained piezoelectric/electrostrictive film type device was confirmed with an electron microscope, any coat layer was not formed, and hollows in the micro-pores opened in the piezoelectric/electrostrictive layer surface were held.

### (Example 2)

The piezoelectric/electrostrictive film type device was manufactured in the same manner as in Example 1 except that the fluorine-based polymer compound dissolved in hydrofluoroether by an amount of 1% (solid content concentration) (RFH-02 manufactured by Hishie Kagaku Kabushiki Kaisha) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Example 3)

The piezoelectric/electrostrictive film type device was manufactured in the same manner as in Example 1 except that the fluorine-based polymer compound dissolved in hydrofluoroether by an amount of 0.2% (solid content concentration) (RFH-10 manufactured by Hishie Kagaku Kabushiki Kaisha) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Example 4)

The piezoelectric/electrostrictive film type device was manufactured in the same manner as in Example 1 except that the fluorine-based polymer compound dissolved in hydrofluoroether by an amount of 0.3% (solid content concentration) and further mixed with the colorant (RFH-10 manufactured by Hishie Kagaku Kabushiki Kaisha) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Example 5)

The piezoelectric/electrostrictive film type device was manufactured in the same manner as in Example 1 except that the fluorine-based polymer compound dissolved in hydrofluoroether by an amount of 1% (solid content concentration) and further mixed with dispersed polytetrafluoroethylene (PTFE) by 0.2% (solid content concentration) (total solid content concentration of 1.2%) (RFH-10P manufactured by Hishie Kagaku Kabushiki Kaisha) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Example 6)

The piezoelectric/electrostrictive film type device was manufactured in the same manner as in Example 1 except that the silicone solution containing metaxylene hexafluoride as the major component (KP-801M manufactured by Shin-Etsu Chemical Co., Ltd., 95% or more of metaxylene hexafluoride) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Example 7)

The piezoelectric/electrostrictive film type device was manufactured in the same manner as in Example 1 except that 3, 3, 3-trifluoropropyl trimethoxysilane (organo-silane KBM-7103 manufactured by Shin-Etsu Chemical Co., Ltd.) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Example 8)

The piezoelectric/electrostrictive film type device was manufactured in the same manner as in Example 1 except that the acetic ether solution (CT-301S-2 manufactured by Kabushiki Kaisha Asahi Kagaku Kenkyusho) was used as the surface modifier.

When the piezoelectric/electrostrictive layer surface of the obtained piezoelectric/electrostrictive film type device was confirmed with the electron microscope, any coat layer was not formed, and the hollows in the micro-pores opened in the piezoelectric/electrostrictive layer surface were held.

### (Comparative Example 1)

The piezoelectric/electrostrictive film type device was manufactured in the same manner as in Example 1 except that the surface modification was not performed.

### (Comparative Example 2)

The piezoelectric/electrostrictive film type device was manufactured in the same manner as in Example 1 except that a coat agent formed of a silicone resin was applied instead of the surface modifier.

### (Evaluation)

For the piezoelectric/electrostrictive layer of Comparative Example 1 which was not subjected to the surface modification and which did not include any coat layer, in the insulation test, a direct-current resistance was several tens of MΩ before the device was disposed in the constant temperature/humidity bath. On the other hand, after the device was disposed in the constant temperature/humidity bath, the resistance dropped down to several KΩ. On the other hand, for the piezoelectric/electrostrictive film type device of Comparative Example 2 including the coat layer stacked on the pie-zoelectric/electrostrictive layer, substrate, and upper electrode, the drop of the direct-current resistance was not recognized before/after disposing the device in the constant temperature/humidity bath. Additionally, the flexural displacement before disposing the device in the constant temperature/humidity bath dropped by 10% as compared with the piezoelectric/electrostrictive film type device of Comparative Example 1.

On the other hand, for the piezoelectric/electrostrictive film type device of Example 1 subjected to the surface modification, the direct-current resistance did not drop before/after disposing the device in the constant temperature/humidity bath. Additionally, the flexural displacement before disposing the device in the constant temperature/humidity bath did not drop at all even as compared with the piezoelectric/electrostrictive film type device of Comparative Example 1 not including any coat layer.

As described above, according to the present invention, there can be provided the piezoelectric/electrostrictive film type device in which the flexural displacement is not reduced and in which the dielectric breakdown or peel of the piezoelectric/electrostrictive layer does not occur and which is superior in durability. Especially in the so-called sandwiched piezoelectric/electrostrictive film type device in which the number of piezoelectric/electrostrictive layers is small, the driving of the piezoelectric/electrostrictive layer is hardly restricted and the flexural displacement is hardly reduced as compared with the piezoelectric/electrostrictive film type device in which the piezoelectric/electrostrictive layer is coated.

## Claims

1. A piezoelectric/electrostrictive film type device comprising: a substrate formed of a ceramic, and a piezoelectric/electrostrictive operation portion in which at least one piezoelectric/electrostrictive layer and at least one pair of electrodes electrically connected to the piezoelectric/electrostrictive layer are stacked on the substrate,
wherein a water repellent surface is formed on at least one of outer surface of the piezoelectric/electrostrictive layer and an upper electrode of said at least one pair of electrodes.

2. A piezoelectric/electrostrictive film type device according to claim 1,
wherein said water repellent surface is modified in such an extent that infiltration of moisture into micro-pores opened in at least one of the outer surface of the piezoelectric/electrostrictive layer and the upper electrode of said at least one pair of electrodes, and/or into a gap between the substrate and the piezoelectric/ electrostrictive layer is sufficiently inhibited.

3. A piezoelectric/electrostrictive film type device according to claim 1 or 2, wherein said water repellent surface is provided by a fluorine-containing polymer bonded to the outer surface of the piezoelectric/electrostrictive layer and/or the upper electrode.
